Europäisches Patentamt

European Patent Office

Office européen des brevets

(11) Publication number: **0 472 866 A2**

# EUROPEAN PATENT APPLICATION

(21) Application number: **91111384.3**

(22) Date of filing: **09.07.91**

(51) Int. Cl.5: **H01L 21/324, H01L 21/52**

(30) Priority: **23.07.90 US 556821**

(43) Date of publication of application:
**04.03.92 Bulletin 92/10**

(84) Designated Contracting States:
**BE DE FR GB LU NL**

(71) Applicant: **NATIONAL SEMICONDUCTOR CORPORATION**
**2900 Semiconductor Drive P.O. Box 58090**
**Santa Clara California 95051-8090(US)**

(72) Inventor: **Fisch, David E.**
**282 South Bayview Avenue**
**Sunnyvale, CA 94086(US)**

(74) Representative: **Sparing Röhl Henseler**
**Patentanwälte European Patent Attorneys**
**Rethelstrasse 123**
**W-4000 Düsseldorf 1(DE)**

(54) Ferroelectric device packaging techniques.

(57) A technique for packaging circuit die having ferroelectric components to minimize the exposure thereof to hydrogen. The outgassing of hydrogen from traditional gold-plated, side-brazed lids is eliminated either by adhesively adhering such lid to a ceramic mounting base, or by soldering an unplated lid to the ceramic base. Other packaging techniques of the invention include the use of a glass frit seal with a cerdip package, and prebake steps and epoxy curing steps in an oxygen-rich ambient to offset the presence of any hydrogen such that degradation of the ferroelectric components is reduced.

FIG. 3

Packaging techniques for microelectronic devices have developed into a highly specialized field. It is not surprising, therefore, that substantial efforts and expense have been expended to package microelectronics and integrated circuits to satisfy a host of requirements, specifications and needs.

The packaging of microelectronic circuits involves the protective encapsulation or enclosure of the chip or circuit die to protect it both mechanically and from the environment, while at the same time permitting external connection for accessing the electrical circuits. The selection or development of a package involves numerous considerations, including heat transfer, mechanical shock capabilities, humidity, electrical resistance, hermetic sealing, radiation resistance, etc. In view that the packaging of integrated circuits is an extremely important aspect, standards have been established by specialized committees, such as EIA/JEDEC.

Examples of integrated circuit packaging technologies include plastic dual-in-line packages in which the integrated circuit die is encapsulated in a nonconductive plastic compound. The compound can withstand solder temperatures with no deformation, and circuit operation remains stable in high humidity conditions. While such a packaging technique results in a low cost product, the sealing capability of the plastic material can fail under adverse conditions.

Other types of dual-in-line packages include ceramic package materials having a ceramic base and a ceramic cover with a conductive lead frame providing external electrical connections. The ceramic base and cover are hermetically sealed with a glass compound. Such a package is commercially known as a "cerdip."

Another ceramic packaging technique involves a ceramic base and a gold-plated metal cap or lid soldered to the ceramic to thereby provide a high quality hermetic seal. Such a device is known as a side-brazed ceramic package. This type of package has extremely high quality sealing capability, and complies with stringent military specifications.

A ceramic flat package provides a hermetically sealed and electrically nonconductive base with an external pin configuration which is different from the dual-in-line packages.

A popular and emerging package for large scale integration and very large scale integration chips is the leadless ceramic chip carrier. This type of package has a unique electrical terminal configuration which allows a high density arrangement of a number of such chip carriers on a printed circuit board.

In the development of new types of circuits and circuit technologies, the normal practice is to package such devices using currently-available, well-known technologies. One new and emerging technology is the development of nonvolatile circuits using ferroelectric materials. Such materials can be polarized in one state, or another state to store digital signals. The polarization states remain even after electrical power is removed from the circuits, thereby providing nonvolatile storage. The preparation of ferroelectric materials for use in memory circuits is disclosed in U.S. Pat. No. 4,759,823, assigned to the assignee hereof.

Although the development of ferroelectric materials for use in nonvolatile storage circuits has been carried on for a number of years, it is only recently that such circuits are being marketed and made commercially available. It is believed that the applicant was the first to realize that conventional packaging techniques are ill-suited for use with ferroelectric material and similar components. More specifically, it was found that the exposure of ferroelectric material to hydrogen during conventional packaging processes significantly and adversely affects the ability of the ferroelectric material to maintain polarization states. In other words, the remanent properties of the ferroelectric material are degraded due to the chemical reducing reaction of hydrogen with the ferroelectric material. Indeed, the remanent properties of the ferroelectric material, when processed to fabricate capacitors, can be sufficiently degraded that the capacitor lacks any ability to store polarization states, and thus functions similar to a linear capacitor. The hydrogen reducing effects on such ferroelectric material can render storage circuits entirely volatile, and therefore unfit for use for the intended purpose.

From the foregoing, it can be seen that a need exists for improved techniques for packaging ferroelectric components. A further need exists for packaging ferroelectric components to provide high quality components, while yet employing conventional packaging apparatus and materials.

In accordance with the present invention, as defined in the independent claims, disclosed is a technique for packaging ferroelectric circuits so that the remanent properties thereof are not degraded, or if degraded during certain processing steps, are thereafter rejuvenated. The techniques disclosed herein thus substantially reduce or eliminate the disadvantages and shortcomings associated with the prior art packaging techniques.

In accordance with an important feature of the invention, a semiconductor chip, or die, having ferroelectric components is packaged in an environment having little or no hydrogen. In accordance with a preferred form of the invention, a ferroelectric circuit die is physically attached to a die attach island formed within a cavity of a ceramic mounting base. The die bond pads are attached by wires to the ceramic mounting base lead frame. The ceramic material itself is of a low hydrogen content and thus is well adapted for use in packaging the ferroelectric die. A ceramic cover is then set on the ceramic base and the composite structure is subjected to a prebake temperature in which hydrogen in any of the materials is outgassed and thus removed from the cavity of the ceramic base, and from the environment of the ferroelectric circuit die. The prebake temperature is then increased or ramped upwardly to a sealing temperature, wherein a glass frit between the ceramic mounting base and the ceramic cover fuses the parts together and provides a hermetic seal. The sealing temperature is above the Curie temperature of the ferroelectric material and thus if the ferroelectric properties of the components was degraded during fabrication, the high temperature tends to "deage" the material. Importantly, the foregoing is conducted in an oxygen-rich ambient so that in the event any hydrogen remains in the environment of the ferroelectric circuit die, the remanent properties thereof will not be adversely affected.

In accordance with an alternative packaging technique of the invention, a ferroelectric circuit die is packaged using the side-brazed ceramic packaging technique. In this packaging process, it has been found that the conventional gold-plated lids significantly contribute to the generation of hydrogen during the high temperature sealing step. It has also been found that with this technique, an oxygen-rich environment cannot be effectively employed, as the resulting oxidation adversely affects the solder seal between the gold-plated lid and the ceramic mounting base. According to the invention, several options are available. First, the gold-plated lids can be utilized, but epoxied or adhered to the ceramic mounting base. With this technique, an oxygen-rich environment can be advantageously utilized to offset the generation of any hydrogen, and no ill effects are realized as no solder sealing is employed. Secondly, non-plated metal lids, such as nickel, which are also not plated with gold can be epoxied or otherwise adhered to the ceramic mounting base. In addition, lids constructed of ceramic material can be epoxied to the ceramic case. Preferably, an epoxy sealing step can be carried out in an oxygen-rich environment to offset the presence of any hydrogen, while yet maintaining a high quality hermetic seal.

Yet another alternative is presented according to the invention. Non-gold-plated lids, such as nickel material, can be soldered or side-brazed to the ceramic mounting base. Since plating is not employed, the generation of hydrogen is minimized.

The invention can also be used to advantage in the plastic encapsulation of ferroelectric component die attached to a lead frame. Preferably, the lead frame and attached ferroelectric die undergo a prebake at a temperature above the Curie point, prior to the plastic encapsulation. The high temperature prebake is preferably carried out in a rich oxygen environment to replace the oxygen molecules lost from the ferroelectric material during previous processing steps. Again, this process step deages the ferroelectric components prior to the lower temperature plastic molding steps. The use of a plastic which does not outgas hydrogen is preferable for use according to the invention. Also, low temperature post-mold curing steps enable the plastic to cure, without significant outgassing of hydrogen within the package.

In accordance with another feature of the invention, the semiconductor wafer on which the ferroelectric die are fabricated can be processed to minimize the exposure thereof to hydrogen. Rather than employing conventional water-cooled wafer cutting apparatus, the semiconductor wafers can be scribed with a diamond blade and broken into the individual circuit die. In this manner, the use of water is eliminated, which is often the source material for the generation of hydrogen.

Further features and advantages will become apparent from the following and more particular description of the preferred and other embodiments of the invention, as illustrated in the accompanying drawings in which like reference characters generally refer to the same parts, elements or functions throughout the views, and in which:

FIG. 1 is an exploded isometric view of a cerdip package for packaging a ferroelectric circuit die;

FIG. 2 is an exploded isometric view of a side-brazed ceramic package for packaging a ferroelectric circuit die;

FIG. 3 is a flow chart illustrating the process steps for packaging a ferroelectric circuit die according to various embodiments of the invention;

FIG. 4 is an exploded isometric view of a plastic packaging operation involving a ferroelectric circuit die; and

FIG. 5 is a flow chart illustrating the major steps in fabricating a plastic packaged ferroelectric component.

Disclosed herein are various techniques for packaging ferroelectric components to reduce or substantially eliminate the effects of hydrogen on the ferroelectric material. It should be understood that the current state of the art in high quality integrated circuit packaging is the use of side-brazed ceramic packages. Such type of packages comply with military specification standards and thus yield high quality devices. According to standard side-brazing packaging techniques, the temperature of the package parts is raised in a low oxygen ambient to outgas various products. The oxygen content of the ambient is maintained at zero or at a very low level to reduce oxidation and its adverse effects on the solder seal of the gold-plated lid. On the other hand, the hydrogen reducing effects enhance the solder seal. This hydrogen environment is highly undesirable for packaging ferroelectric components, in that the outgassing of the gold-plated lids produces substantial amounts of hydrogen, and the low oxygen ambient cannot offset the effects of the hydrogen on the ferroelectric material. As noted above, it is believed that the applicant was the first to appreciate the adverse affects of hydrogen on ferroelectric material, and was the first to overcome the problem by the packaging techniques set forth below.

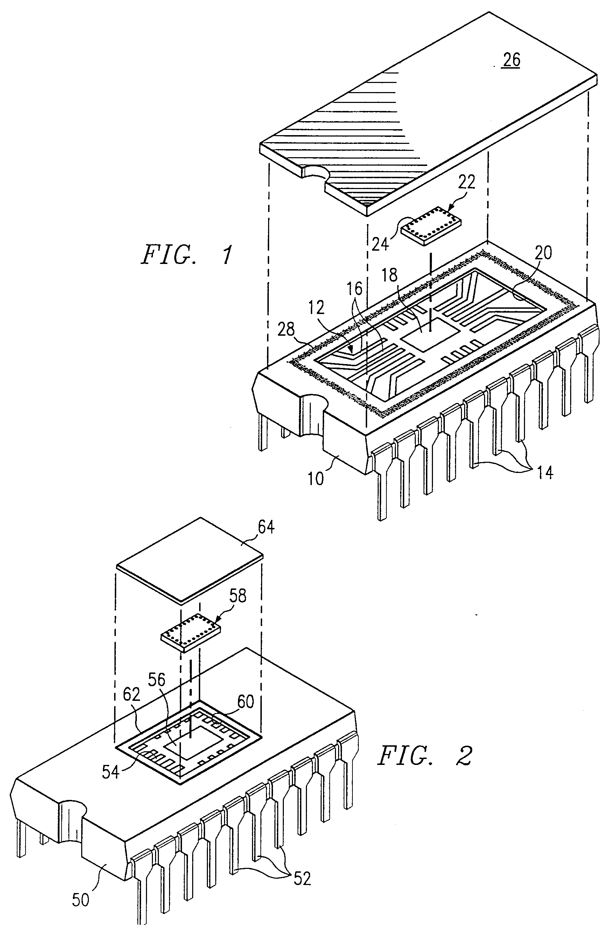

FIGS. 1 and 2 illustrate respectively, cerdip and side-brazed ceramic packages well adapted for packaging ferroelectric circuit dies according to the principles and concepts of the invention. With reference now to FIG. 1, there is shown a cerdip package constructed according to the preferred embodiment of the invention. The various components of the package include a ceramic mounting base 10 having a spider-shaped conductive lead frame 12 formed within the ceramic material. The lead frame 12 includes a number of external terminals 14 for providing solder connections or other types of connections to the package. The lead frame 12 further includes conductor terminations 16 within the package, all formed around a die attach island 18. The internal lead frame terminations 16, as well as the die attach island 18 are accessible within a cavity or recessed area 20 of the ceramic mounting base 10. Importantly, the lead frame 12 and the die attach island 18 can be covered with a eutectic gold, or other suitable conductive material having a very low hydrogen content. It has been found that eutectic gold, as contrasted with plated gold, does not outgas hydrogen and adversely affect ferroelectric material.

A monolithic circuit die 22 having ferroelectric components, such as capacitors, is fabricated independently of the package parts. The circuit die 22 includes a number of surface bond pads 24 for providing electrical access to the circuits of the die. In practice, a circuit die having an area of about twenty square millimeters can have formed thereon millions of circuit components, such as memory cells. To that end, recent developments in ferroelectric materials have made available the integration of volatile static and dynamic memory cells with ferroelectric capacitors to achieve nonvolatile memory cells.

The circuit die 22 is bonded to the die attach island 18 by various conductive or nonconductive materials. When it is desired to insulate the circuit die 22 from the die attach island 18, a polyimide adhesive can be utilized. The polyimide adhesive is cured by subjecting the ceramic mounting base 10 and die 22 adhered thereto according to a temperature profiles recommended by the manufacture of the adhesive. Preferably, the polyimide is cured at a temperature at least higher than the temperature at which the package is sealed. This outgasses any hydrogen and rejuvenates the ferroelectric material before the package is closed and sealed. When it is desired to provide a conductive path between the substrate of the circuit die 22 and the island 18, a conductive silver-filled glass, or a gold eutectic can be utilized. Conductive bonding of the circuit die 22 to the island 18 can be employed when backside contact of the die 22 is required to one of the internal lead frame contacts. After the circuit die 22 has been attached to the die attach island 18, gold eutectic conductors (not shown) are bonded between the die bond pads 24 and the internal terminations 16 of the lead frame 12. In this manner, the circuits of the die 22 can be accessed and exercised by electrical connections to the external terminals 14.

A ceramic cover 26 is effective to enclose the cavity 20 of the ceramic mounting base 10. The ceramic cover 26 is fixed to the ceramic mounting base 10 by the use of a solder glass frit 28 deposited either on the under surface of the cover 26 or on the upper surface of the mounting base 10 or both. The glass frit 28 is preferably of the devitrifying type which is easily wetted and seals to glasses, metals and ceramics. Such a glass frit produces a seal at temperatures below 500° C, has a high mechanical strength, has excellent electrical insulating qualities, but retains acceptable thermal conductivity. The use of such a packaging technique and materials provides a package which is impervious to moisture and gases and meets extremely stringent mechanical and environmental requirements. Plastic packages, while economical and easily fabricated, cannot meet such stringent requirements.

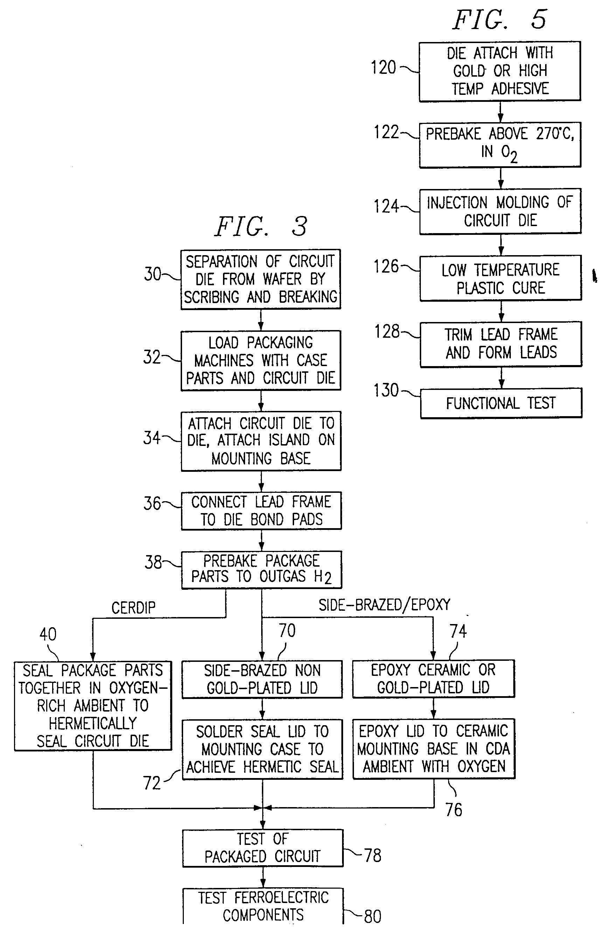

With reference now to FIG. 1 in conjunction with FIG. 3, the steps of the packaging technique are described in more detail. It should be noted that the packaging materials and process apparatus steps can be carried out to achieve the advantages of the invention by utilizing conventional equipment and readily available materials. The packaging steps noted in FIG. 3 can be carried out on conventional circuit packaging conveyor equipment for transporting the package components from one station to another, and with automatic handlers assemble the components together, process the components with various temperatures and in various environments to achieve a hermetically sealed and mechanically protected ferroelectric circuit die.

A packaging conveyor can typically carry about 10-12 packages crossways and spaced apart about one inch lengthwise. Accordingly, a substantial number of packaged components can be produced in a batch. As noted in step 30 of FIG. 3, hydrogen contamination of the ferroelectric die is minimized by scribing and breaking each circuit die from the wafer, rather than by water-cooled sawing techniques. The wafer employed in the sawing process can later be the mechanism for generating hydrogen during the packaging process steps. In any event, a scribe or score line is formed by a diamond blade, or other similar tool, around each die on the wafer. Then, the wafer is broken along the scribe lines into the individual die. This step reduces the chances of hydrogen contamination of the ferroelectric components used on the die.

In step 32, the packaging equipment is loaded with the ceramic mounting bases, the mounting covers and the circuit die. The ceramic mounting base 10 equipped with the lead frame 12 and the die attach island 18 are readily available from vendors as a complete subassembly. The attachment of the circuit die 22 to the island 18, as noted in step 34, is carried out in the manner noted above. In like manner, the electrical connection between the circuit die 22 and the internal lead frame termination 16 can be carried out with automatic equipment (step 36).

The critical packaging step when employing cerdip packaging techniques is the hermetic sealing of the cover 26 to the mounting base 10 so as to minimize exposure of the ferroelectric components on the circuit die 22 to hydrogen.

With respect to step 38, the package parts, including the ceramic cover 26 and the ceramic mounting base 10 with the attached circuit die 22 undergo a prebake to outgas any hydrogen which may be trapped in the various packaging parts. Prebake temperatures of about 400°C for ten minutes are adequate to outgas hydrogen from the package parts. While the prebake step 38 can be carried out in a clean dry air,(CDA) environment, it is more preferable to immerse the package parts in a nitrogen or oxygen ambient, or an ambient in which both such elements are mixed. When packaging ferroelectric components, a CDA environment may allow sufficient moisture to become trapped in the package cavity and produce hydrogen which could then degrade the ferroelectric material.

The prebaked and outgassed package components are then forwarded on the conveyor mechanism to a sealing station where the ceramic cover 26 is hermetically sealed to the ceramic mounting base 10. A sealing temperature of about 440°-460°C is effective to fuse the ceramic parts together at the glass frit interface. Importantly, the sealing temperature is higher than the Curie temperature of ferroelectric material, e.g., 270°C, and thus the ferroelectric components are deaged. As noted above, in order to provide a high quality moisture and gas seal, a glass frit 20 is typically used. It should be understood that when the hermetic seal constraints are not as stringent as required by military standards, other bonding or sealing agents, such as epoxy, can be utilized.

Advantageously, and in contrast with side-brazing gold-plated lids on ceramic mounted bases, the sealing of the ceramic package components with a glass frit or epoxies is not adversely affected by an oxygen-rich ambient in which the sealing process occurs. Step 40 is particularly illustrative of the cerdip package sealing step. A hermetic seal between the ceramic parts is achieved at a temperature of about 440°-460°C, at which temperature the glass frit 28 liquifies and wets both surfaces of the ceramic parts 26 and 10. Importantly, the sealing step is carried out in an oxygen-rich environment to assure that in the event hydrogen is generated or captured within the enclosed cavity 20, the effects thereof will be offset by oxygen.

In accordance with an important feature of the invention, it has been found that the presence of sufficient oxygen, even though hydrogen may also be exposed to the ferroelectric components, prevents degradation of the ferroelectric material. Indeed, it is preferable if the sealing environment includes greater than about 1% oxygen, by weight. It is believed that with the presence of sufficient oxygen, hydrogen constituents, such as $H_2$ and $H_2O$ amounting to less than 5,000 parts per million (ppm) each, will not adversely affect the ferroelectric material of the circuit die 22. As noted, the hydrogen constituent can be elemental hydrogen, or that existing in water ($H_2O$). Since 1% oxygen constitutes about 10,000 ppm, such number of oxygen molecules can replace an equivalent amount of oxygen molecules lost in the ferroelectric material due to the reducing effects of 10,000 ppm of hydrogen constituents. Accordingly, whatever extent hydrogen is exposed to the ferroelectric components, it is expected that degradation thereof can be minimized by introducing at least an oxygen concentration to counteract the number of oxygen molecules given up by the ferroelectric material due to the hydrogen reducing effects.

With reference now to FIG. 2, there is illustrated a side-brazed ceramic package. Such a package includes a ceramic mounting base 50 having formed therein a lead frame comprising external electrical terminals 52 and internal terminating ends 54. The internal terminating ends 54 of the lead frame are disposed around a die attach island 56 to which the monolithic circuit die 58 is bonded. The die attach island 56 and the inner lead frame terminations 54 are accessible within a cavity 60 formed in the top surface of the mounting base 50. While not shown, a sheet of electrical insulating material may be disposed between a metal lid 64 and the circuit die 58 and lead frame terminations 54 to prevent the metal lid from short circuiting the components. A sealing agent 62 is disposed circumferentially around the cavity 60, and is of a particular type depending upon the type of material from which the lid 64 is constructed. For example, if the lid 64 is gold-plated, as is the typical construction, then the sealing agent 62 would comprise a bead of epoxy. Also, a lid construction of ceramic can be sealed to the ceramic mounting base 50 by epoxy. If, on the other hand, the lid 64 is constructed of a non-plated metal, such as nickel, then the sealing agent 62 can be solder. By soldering a non-plated lid 64 to the ceramic mounting base 50, little or no hydrogen is generated and therefore the ferroelectric components on the circuit die 58 are not subject to deterioration due to oxygen deficiency. The plating process involves a solution and an electrical potential. As the solution ionizes, hydrogen ions are formed, which ions can be outgassed and produce the adverse results described above. Hence, plated lids or other plated material in general should not be used in packaging ferroelectric components.

With reference again to FIG. 3, many of the packaging steps 30-38 are also applicable to the packaging of ceramic devices similar to that shown in FIG. 2. The steps 30-38 have been described above, and thus further description is not necessary in connection with side-brazed or epoxied lids 64. In any event, steps 70 and 72 are applicable for packaging ferroelectric component circuit dies in ceramic packages having high quality hermetic seals with the lid structures 64. It has been found that a solder or similar type of bond between the ceramic mounting base 50 and the lid 64 provides a superior hermetic seal over either glass or epoxies. However, as noted above, packaging techniques employing gold-plated lids and oxygen rich environments do not result in devices having both undamaged ferroelectric material and excellent hermetic solder seals.

As illustrated, in process step 70 a non-gold-plated lid is employed so that the heating thereof during the bonding process does not outgas hydrogen which is detrimental to the ferroelectric material of the circuit die 22. The non-gold-plated lid is side-brazed to the mounting base 50 by employing a solder seal. The side-brazing of the lid 64 to the mounting base 50 provides a high quality seal, as noted above. Preferably, a bead of solder 62 (FIG. 2) is formed around the perimeter of the cavity 60 so that when the parts are heated to a high temperature, the lid 64 is sealed to the base 50. Materials suitable for such lid use are those which are preferably non-plated metals having a low hydrogen content, such as nickel. Other metals can be employed which can be easily soldered, brazed or otherwise bonded to the mounting base 50 to provide a high quality seal.

Packaging steps 74 and 76 illustrate yet other alternatives for packaging a circuit die 58 in a side-brazed type of package. According to this packaging technique, a lid 64 is adhesively bonded to the ceramic mounting base 50, and thus the sealing agent 62 would comprise an adhesive, such as epoxy. The material of the lid 64 in this instance can be ceramic or a conventional gold-plated lid. Since adhesive curing is carried out at a temperature much lower than solder bonding, less hydrogen is outgassed from the lid, should it be of the plated type. However, as noted in packaging step 76, the adhesive sealing step is carried out in a clean dry air ambient with oxygen so that at least a combination of oxygen and hydrogen, if any, is sealed within the cavity 60. As described above, with a sufficient amount of oxygen, the presence of hydrogen does not appear to be detrimental to the ferroelectric material. While epoxies in general do not provide a hermetic seal achieving the quality of solder or brazing, the adhesive approach is economical, is easily carried out, and requires no special materials. Epoxies obtainable from Semi-Alloy Inc., Dallas, Texas, are suitable for use in adhering lids 64 to the ceramic mounting base 50. While ceramic and gold-plated lids are preferable for epoxy sealing, other materials having adequate packaging properties may also be suitable for use in this embodiment of the invention.

After the circuit die 22 or 58 has been packaged in the manner described above, the device is forwarded to a test station for conducting electrical tests thereon, as shown in step 78. Electrical testing of the circuit die is carried out by connecting the packaged device in an automatic handler of the type adapted for carrying out full functional tests to determine operability thereof. General electrical tests are well known in the art and are particularized to the specific circuit formed in the die.

In addition, and as shown in step 80, the ferroelectric components of the circuit die 22 or 58 are also tested to ascertain whether or not the ferroelectric material has been degraded as a result of exposure to hydrogen during the packaging process. As is presently understood, the ferroelectric material degrades very quickly in the presence of hydrogen, and is readily ascertainable by electrically testing the ferroelectric components. Analog tests can be conducted on the ferroelectric components of the circuit die via the external terminals of the packaged device. The remanent properties of the ferroelectric material can be tested to determine if the capability of the material to store polarization states complies with predetermined criteria. For example, a voltage can be applied across a ferroelectric capacitor formed on the die for storing a first polarization state. Then, the voltage is removed and the extent of polarization can be read from the capacitor. The polarity of the voltage applied across the ferroelectric capacitor can then be reversed, and the extent or amplitude of the other polarization state can be read. If the polarization states which are representative of the remanent properties of the ferroelectric material are severely degraded, it can be assumed that the circuit die was exposed to hydrogen.

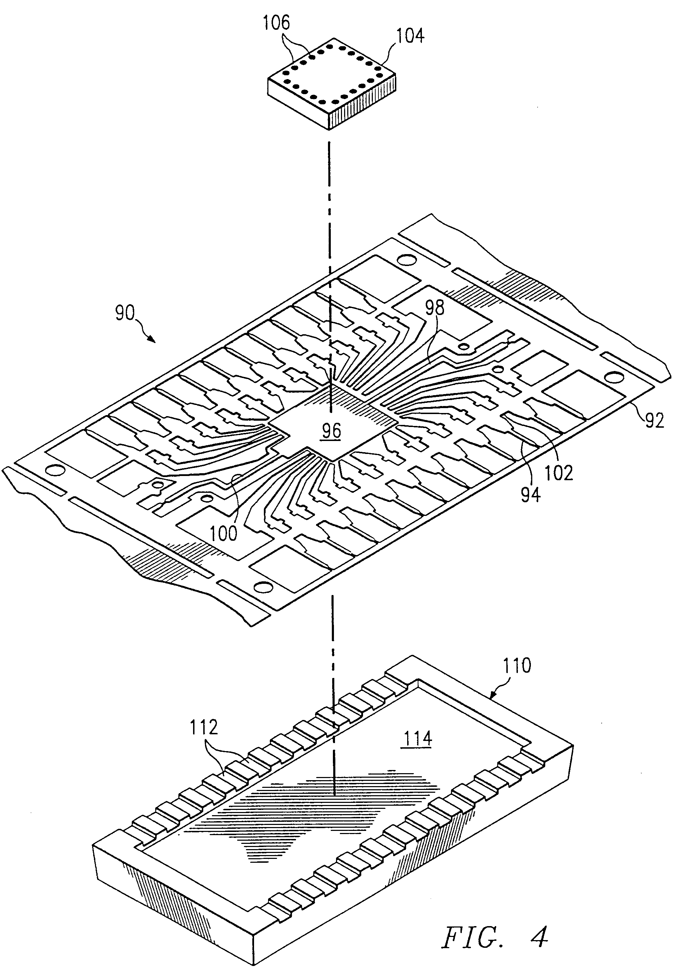

FIG. 4 depicts a plastic packaging technique of the invention for encapsulating ferroelectric components. Show is a spider-shaped lead frame 90 connected to other similar lead frames. The lead frame 90 is constructed of a metal stamped in a pattern to provide a plurality of external contact legs 94 which have internal ends disposed peripherally around a die attach island 96. The die attach island 96 is connected by two support legs 98 and 100 which support the die attach island 96 with respect to the frame 92. For support, each contact leg 94 is also temporarily connected together by a support interconnection 102. After encapsulation, the interconnecting leg supports 102 are removed, as is the frame 92. Thus, each leg 94 is electrically isolated from each other, as well as from the die attach island 96.

A circuit die 104 having one or more ferroelectric components is then bonded to the die attach island 96 of the lead frame 90. As with the ceramic-type of packages described above, the bond pads 106 of the circuit die 104 are connected to the internal ends of the contact legs 94. Also as noted above, the circuit die 104 can be soldered or otherwise adhesively bonded to the die attach island 96. Indeed, high temperature polyimide adhesives are well adapted for use with the invention so that prebaking of the lead frame 90 and attached circuit die 104 to temperatures above the Curie point can deage the ferroelectric components without destroying the quality of the die attach bond.

After the prebake step to outgas hydrogen from the various package components, the lead frame 90, with attached circuit die 104, is placed in a plastic mold, the bottom half of which is shown as reference character 110. A similar top half of the mold is not shown for purposes of clarity. In any event, plastic encapsulating molds for dual-in-line packages are well known in the art. The mold includes a number of channels 112 for receiving therein the lead frame contact legs 94. The interconnecting supports 102 between the contact legs 94 are disposed outside of the mold, thereby serving to center the die attach island 96 and the circuit die 104 with respect to a cavity 114 formed within the mold 110. The top and bottom mold parts are pressed together with the contact legs 94 disposed in the channels 112 to thereby provide an internal sealed chamber. While not shown, a molten plastic is injected into the internal chamber 114 above and below the lead frame 90 and the circuit die 104, thereby encapsulating the components. Preferably, a high quality molding plastic having a low permeability to moisture is desirable. Moreover, a low-hydrogen content plastic is preferable to reduce the possibility of outgassing hydrogen.

Having described the plastic packaging structure, reference is made to FIG. 5 which is a flow chart illustrating the major plastic packaging steps according to the invention. However, even before packaging, certain measures can be taken to minimize exposure of the ferroelectric die to water or moisture. For example, a silicon nitride passivation layer can be deposited over the surface of the entire wafer. Such a layer provides a hermetic seal and a barrier to moisture. In addition, or in lieu thereof, polyimide materials and hydrophobic layers can be spun on the wafer to achieve the moisture barrier properties. The wafer can then be scribed and broken into the individual die.

Step 120 illustrates the process in which the circuit die 104 is attached to the island 96 with eutectic gold or a high temperature adhesive. It is believed that there are available polyimide-type adhesives which can withstand temperatures above $270^{\circ}$ C, the Curie temperature of ferroelectric material. At the same time, a drop of polyimide adhesive can be dropped on the surface of the die to provide a moisture barrier. Other hydrophobic materials can be used with equal effectiveness.

Next, the lead frame 90 and attached circuit die 104 undergo a prebake step, in which the temperature thereof is raised above $270^{\circ}$ C to outgas any hydrogen in the materials, as well as to deage the ferroelectric material (step 122). As noted above, the deaging of the ferroelectric material provides a rejuvenating affect should substantial aging occur during the previous processing steps. Again, the prebake step is preferably undertaken in an oxygen rich environment, for the reasons described above.

Step 124 depicts the packaging steps in which the prebaked lead frame is situated between the mold halves so that plastic can be injection molded round the circuit die 104 and the internal parts of the lead frame 90. After the injected plastic has solidified, the mold halves are removed and the lead frame with the molded plastic progresses through an oven where the plastic is subjected to a low temperature cure, as shown in step 126. Preferably, the temperature is about $175^{\circ}$ C to prevent outgassing of hydrogen in the sealed plastic package. The curing step can be carried out for about six hours. The next step in the fabrication process involves the separation of the lead frame components and the trimming thereof, as shown in step 128. Also, the contact legs 94 are bent at an angle with respect to the encapsulated body using conventional lead forming equipment. The complete packaged ferroelectric components are then functionally tested in the manner noted above. The functional test is noted by step 130. A plastic packaged ferroelectric circuit die, or other type of component, packaged in accordance with the foregoing provides a high quality and reliable circuit. The processing steps are carried out in conditions which reduce the possibility or likelihood of hydrogen contaminating the ferroelectric components.

From the foregoing, various techniques have been disclosed for packaging ferroelectric component circuit dies to achieve reliable and high quality packaged devices. An important technical advantage of the invention is that by taking special packaging precautions, high quality and low or zero hydrogen content seals can be obtained, without resort to specialized equipment or materials. A primary technical advantage of the invention is that a mechanism is recognized which is detrimental to ferroelectric material, and a remedy is provided for obviating the adverse affects thereof.

While the preferred and other embodiments of the invention have been disclosed with reference to specific packaging steps and techniques, it is to be understood that many changes in detail may be made as a matter of engineering choices without departing from the spirit and scope of the invention, as defined by the appended claims.

**Claims**

1. A method for packaging ferroelectric components, comprising the steps of:

    attaching a semiconductor die having ferroelectric components to a mounting base;

    attaching electrical conductors between a lead frame of said mounting base to bond pads of said circuit die;

    elevating the ambient temperature of the mounting base and the circuit die to outgas hydrogen therefrom; and

    hermetically sealing the circuit die in the mounting base in an oxygen environment.

2. The method of Claim 1, wherein the oxygen environment constitutes an ambient with more than about 1% of oxygen, by weight.

3. The method of Claim 1, further including scribing a semiconductor wafer into individual circuit die having ferroelectric components, and breaking the wafer along scribe lines to define each die.

4. The method of Claim 1, further including fixing a lid to said mounting base by adhesive techniques.

5. The method of Claim 4, further including adhering said lid with an epoxy-based adhesive.

6. The method of Claim 5, further including curing the epoxy adhesive at an elevated temperature, which temperature is also effective to accomplish said outgassing of hydrogen.

7. The method of Claim 1, further including fixing a lid to said mounting base with a glass frit seal.

8. The method of Claim 1, further including fixing an unplated lid to said mounting base with an adhesive to form a hermetic seal to said circuit die.

9. The method of Claim 1, wherein said hermetic seal is carried out in an oxygen ambient in which a combination of $H_2O$ and $H_2$ are less than 5,000 ppm and the oxygen is greater than 1%.

10. The method of Claim 1, wherein said hermetic sealing step is carried out in an ambient in which the oxygen concentration exceeds the total hydrogen constituent including that in $H_2O$.

11. The method of Claim 1, further including bonding said circuit die to a ceramic mounting base.

12. The method of Claim 11, further including bonding the circuit die to the ceramic base with a polyimide type adhesive.

13. The method of claim 12, further including curing the polyimide adhesive at a temperature greater than a temperature at which the circuit die is hermetically sealed in the mounting base.

14. The method of Claim 1, wherein said die is hermetically sealed with plastic.

15. A packaged circuit die fabricated in accordance with the method of Claim 1.

16. A method for packaging a semiconductor die having ferroelectric components in a side-brazed package, comprising the steps of:

    attaching a semiconductor die having ferroelectric components to a mounting base;

attaching electrical conductors between a lead frame of said mounting base and bond pads of said circuit die;

adhering a lid to the package case with an adhesive for providing a hermetic seal to the circuit die.

17. The method of Claim 16, further including adhering a nonmetal lid of low hydrogen content to the mounting base.

18. The method of Claim 17, further including adhering a ceramic lid to the mounting base.

19. The method of Claim 17, further including adhering an unplated lid to said mounting base.

20. The method of Claim 16, further including adhering said lid to said mounting base with an epoxy-based adhesive.

21. The method of Claim 16, further including mounting said circuit die to a ceramic mounting base.

22. The method of Claim 16, further including attaching the die to the mounting base with a polyimide type adhesive.

23. A circuit die packaged in accordance with the method of Claim 16.

24. A method for packaging semiconductor die having ferroelectric components, comprising the steps of:

bonding the semiconductor die to a eutectic gold die attach island of a mounting base;

connecting eutectic gold wires between bond pads of the circuit die and eutectic gold lead frame conductors of the mounting base;

heating the package case and an unplated lid to outgas hydrogen therefrom; and

attaching the unplated lid over an opening of the mounting base to thereby hermetically seal the circuit die therein in a non-reducing ambient such that the ferroelectric material is not adversely affected.

25. The method of Claim 24, further including attaching the unplated lid by an adhesive.

26. The method of Claim 25, further including attaching the unplated lid with an epoxy-based adhesive having a low hydrogen content.

27. The method of Claim 24, further including carrying out the lid attaching step in an oxygen-rich ambient.

28. The method of Claim 27, wherein said oxygen ambient is greater than 1% oxygen by weight.

29. The method of Claim 24, further including sectioning a wafer into individual circuit die by scribing lines around each die, and breaking the wafer along the scribe lines.

30. A packaged circuit fabricated in accordance with the method of Claim 24.

31. A method for packaging semiconductor die having ferroelectric components, comprising the steps of:

bonding a semiconductor die to a die attach island of a lead frame;

prebaking the led frame and attached die to a temperature above the Curie temperature of ferroelectric material;

encapsulating the die with a plastic material; and curing the plastic encapsulant.

32. The method of Claim 31, further including adhering the die to the die attach island with a polyimide adhesive.

33. The method of Claim 31, further including bonding the die to the die attach island using a non-plated eutectic gold.

FIG. 1

FIG. 2

## FIG. 5

120 — DIE ATTACH WITH GOLD OR HIGH TEMP ADHESIVE

↓

122 — PREBAKE ABOVE 270°C, IN $O_2$

↓

124 — INJECTION MOLDING OF CIRCUIT DIE

↓

126 — LOW TEMPERATURE PLASTIC CURE

↓

128 — TRIM LEAD FRAME AND FORM LEADS

↓

130 — FUNCTIONAL TEST

## FIG. 3

30 — SEPARATION OF CIRCUIT DIE FROM WAFER BY SCRIBING AND BREAKING

↓

32 — LOAD PACKAGING MACHINES WITH CASE PARTS AND CIRCUIT DIE

↓

34 — ATTACH CIRCUIT DIE TO DIE, ATTACH ISLAND ON MOUNTING BASE

↓

36 — CONNECT LEAD FRAME TO DIE BOND PADS

↓

38 — PREBAKE PACKAGE PARTS TO OUTGAS $H_2$

CERDIP → 40 — SEAL PACKAGE PARTS TOGETHER IN OXYGEN-RICH AMBIENT TO HERMETICALLY SEAL CIRCUIT DIE

SIDE-BRAZED/EPOXY

70 — SIDE-BRAZED NON GOLD-PLATED LID

↓

72 — SOLDER SEAL LID TO MOUNTING CASE TO ACHIEVE HERMETIC SEAL

74 — EPOXY CERAMIC OR GOLD-PLATED LID

↓

76 — EPOXY LID TO CERAMIC MOUNTING BASE IN CDA AMBIENT WITH OXYGEN

↓

TEST OF PACKAGED CIRCUIT — 78

↓

TEST FERROELECTRIC COMPONENTS — 80

11

*FIG. 4*